(19)

Europäisches
Patentamt
European
Patent Office
Office européen
des brevets

(11)     **EP 2 696 227 B1**

(12)     **EUROPEAN PATENT SPECIFICATION**

(45) Date of publication and mention
of the grant of the patent:
**25.09.2019   Bulletin 2019/39**

(51) Int Cl.:
*G02B 6/125* *(2006.01)*          *G02F 1/01* *(2006.01)*
*H01S 5/40* *(2006.01)*          *H01S 5/14* *(2006.01)*
*H01S 5/026* *(2006.01)*

(21) Application number: **12179654.4**

(22) Date of filing: **08.08.2012**

(54) **Directional coupler and optical waveguide**

Richtkoppler und Lichtwellenleiter

Coupleur directionnel et guide d'ondes optiques

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**12.02.2014   Bulletin 2014/07**

(73) Proprietor: **Fraunhofer-Gesellschaft zur
Förderung der
angewandten Forschung e.V.
80686 München (DE)**

(72) Inventors:
• **Grote, Norbert
  14052 Berlin (DE)**
• **Zhang, Ziyang
  10557 Berlin (DE)**
• **Soares, Francisco
  10625 Berlin (DE)**
• **Genrich, Garri
  14469 Potsdam (DE)**

(74) Representative: **Maikowski & Ninnemann
Patentanwälte Partnerschaft mbB
Postfach 15 09 20
10671 Berlin (DE)**

(56) References cited:
**WO-A2-02/065600          DE-B4- 10 025 307
JP-A- H0 758 389          US-A- 5 732 102
US-A- 5 857 039          US-A- 6 002 823
US-A1- 2002 018 507          US-A1- 2003 174 950
US-A1- 2003 214 991          US-A1- 2005 089 291
US-A1- 2006 039 647          US-A1- 2007 058 900
US-A1- 2010 142 568          US-B1- 6 282 335
US-B1- 6 311 004**

• **MARCUSE D: "DIRECTIONAL COUPLERS MADE
OF NONIDENTICAL ASYMMETRIC SLABS. PART
II: GRATING-ASSISTED COUPLERS", JOURNAL
OF LIGHTWAVE TECHNOLOGY, IEEE SERVICE
CENTER, NEW YORK, NY, US, vol. LT-05, no. 2, 1
February 1987 (1987-02-01), pages 268-273,
XP000886099, ISSN: 0733-8724**

**Description**

The invention relates to a directional coupler according to claim 1.

Optical directional couplers comprising at least one polymer waveguide are known from the prior art. In particular, such a directional coupler could be used as a tuneable wavelength filter as described in DE 1 002 53 07 B4.

Further, US 6 311 004 B1 discloses a hybrid integrated optical device with silica waveguides for transport and polymer or hybrid silica/polymer waveguides far refractive-based active functions within a single integrated photonic circuit.

Moreover, US 5 857 039 B1 describes a directional optical coupler including at least two optical guide cores, in silica, lying on a cladding in a mineral dielectric material, and a covering layer in a polymer material, which covers the two optical guide cores.

US 6 282 335 discloses a plurality of glass waveguides arranged in a first plane, wherein in an overlying plane there is arranged at least one polymer waveguide which forms an acute angle with the glass waveguides.

It is an objective of the present invention to provide a directional coupler with enhanced tuning capabilities.

According to the invention, a directional coupler is provided, comprising

- a first and a second optical waveguide extending at least partially parallel to one another, wherein
- the first optical waveguide has a core that at least partially comprises or consists of a dielectric material; and
- a polymer cladding forming the cladding of both the first and the second optical waveguide, wherein
- the first and the second optical waveguide are arranged on a substrate in such a way that they extend in common plane running essentially parallel to the substrate, wherein
- the second optical waveguide has a polymer core.

The first and the second optical waveguide each comprises an input ending providing an input port of the directional coupler and an output ending providing an output port of the directional coupler. Further, the optical waveguides are configured and arranged relative to one another in such a way that an optical wave coupled into one of the two waveguides via its input ending will be transferred to the other waveguide only if the wavelength of the optical wave fed into the waveguide lies in a wavelength range around a (tuneable) centre wavelength. Thus, the directional coupler according to the invention can be operated as a wavelength selective optical filter, wherein the input port of the filter is the input ending of one of the two optical waveguides and the output port of the filter is the output ending of the other optical waveguide. Possible configurations permitting the tuning of the centre wavelength of the filter will be discussed below.

The first and the second optical waveguide are arranged on a substrate (e.g. a silicon substrate or another semi-conductor or non-semi-conductor substrate) in such a way that they extend in a common plane running essentially parallel to the substrate. In other words, the first and the second optical waveguide are arranged in a lateral and not in a vertical configuration. The lateral configuration may have the advantage over a vertical configuration that both the first and the second optical waveguide can be used for changing the centre wavelength of the directional coupler, i.e. for wavelength tuning.

The dielectric core of at least one of the optical waveguides may provide a difference of the effective refractive indices of the two waveguides large enough to enable wavelength tuning by exploiting the well-known principle of grating assisted couplers (as described e.g. in the publication "Directional couplers made of non-identical asymmetrical slabs, Part II: Grating assisted couplers", J. Lightwave Technol. vol. 5, 268-273 (1987), M. Marcuse, which is incorporated by reference herewith). Furthermore, it may also provide a different thermo-optical coefficient, which may improve the tuning characteristics of the directional coupler.

In particular, the directional coupler according to the invention is an asymmetric directional coupler, i.e. the effective refractive index of the first optical waveguide is different from the effective refractive index of the second optical waveguide (taken at the same temperature of the first and the second optical waveguide). According to an embodiment of the invention, the first optical waveguide comprises or consists of a dielectric core configured in such a way that the effective refractive indices of the first and the second optical waveguides differ by some 0.01-0.03, to indicate an exemplary reasonable range. The refractive index of the dielectric core may be significantly higher than the refractive index of the polymer cladding, e.g. the dielectric core material has a refractive index of about 1.8 - about 2 at a wavelength of 1550 nm; in particular, distinctly larger than that of the embedding polymer material with typical values between some 1.35-1.6.

For example, the complete core of the first waveguide is formed by a dielectric material. Suitable dielectric materials for the waveguide core are, for example, silicon nitride ($SiN_x$), silicon oxynitride (SiON), tantalum oxide, titanium oxide and/or aluminium oxide. Of course, other materials can be used as dielectric core material, provided that they exhibits low optical loss (in respect to the used optical wavelengths) and are compatible with the polymer cladding.

Further, the dielectric core of the first optical waveguide of the coupler (different than in, for example, conventional silicon oxide waveguides having a silicon nitride core) may also create a waveguide having a thermo-optical coefficient (TOC) different (e.g. lower) from the TOC of the non-dielectric core waveguide. This is due to the fact that the dielectric core material may have a significantly lower TOC (e.g. about +(1-2)*10$^{-5}$K$^{-1}$) than the polymer cladding (e.g. about -1.1 *10$^{-4}$K$^{-1}$). Taking into account and depending on weighed confinement factors of the light intensity in the cladding and the core, the effective TOC of the dielectric core waveguide may be significantly lower than the TOC of a pure polymer waveguide. The lower TOC of the waveguide may improve the tuning characteristics of the directional coupler.

In an asymmetric directional coupler a periodic variation of the effective refractive index of at least one of the optical coupler waveguides (along the length of the respective optical waveguide) may be provided in order to permit the light fed into one of the waveguides to be transferred to the other coupler waveguide. In particular, one of the waveguides is provided with a grating-like variation of the effective refractive index (e.g. by providing a grating-like variation the dimensions of the waveguide core), i.e. the directional coupler is formed as a "grating assisted coupler" (GAC). In particular, only one of the two coupler waveguides comprises a grating. The grating-like variation of the effective refractive may be achieved by providing a waveguide core whose dimensions (the width measured parallel to the substrate and /or the thickness measured perpendicular to the substrate) vary periodically along at least a portion of the length of the optical waveguide.

In a GAC a transfer of optical power from one of the coupler waveguides into the other one is possible for a resonant coupling wavelength λ (defining the "centre wavelength" mentioned above of the optical filter provided by the directional coupler), wherein λ is given by:

$$\lambda = \Delta n_{eff} \Lambda$$

wherein $\Delta n_{eff}$ is the difference of the effective refractive indices of the first and the second optical waveguide of the directional coupler and $\Lambda$ is the periodic length of the grating.

According to an embodiment of the invention, the thickness and/or the width of the dielectric core of the first optical waveguide varies periodically along the length of the first optical waveguide such that the refractive index grating mentioned above is created. For example, assuming a centre wavelength of λ =1550 nm and $\Delta n_{eff}$= 0.02, which can be real ized because of the dielectric core of the first optical waveguide, a grating period $\Lambda$ of 77.5 μm is required, which can be readily realized by conventional lithographic methods.

Different from a symmetric directional coupler the coupling wavelength (the centre wavelength) of an asymmetric coupler may be changed by changing the effective refractive index difference $\Delta n_{eff}$. The difference $\Delta n_{eff}$ may be changed by changing the effective refractive index of the first and/or the second optical waveguide of the directional coupler, e.g. by changing the temperature of the waveguide(s) (thermo-optic refractive index control) or by applying an electric field across the waveguide(s) if electro-optic polymer material is used in the latter case. Regarding the thermo-optic refractive index control the inducable temperature dependent wavelength change $\Delta\lambda/\Delta T$ is given by:

$$\Delta\lambda/\Delta T = \Delta(\Delta n_{eff} \Lambda)/ \Delta T = (TOC_1 - TOC_2)* \Lambda$$

and

$$\Delta\lambda = (TOC_1 \Delta T_1 - TOC_2 \Delta T_2)* \lambda/\Delta n_{eff}$$

wherein $TOC_1$ and $TOC_2$ are the thermo-optic coefficients of the first and the second optical waveguide, respectively, and $\Delta T_1$ and $\Delta T_2$ is the induced temperature change of the first and the second optical waveguide, respectively.

The directional coupler according to the invention may correspondingly comprise a heating device for heating the first and/or the second optical waveguide. For example, the heating device is configured for heating the first and the second optical waveguide in such a way that the temperature of the first and the second optical waveguide can be altered essentially independently from one another. That is, the two optical waveguides may be sufficiently thermally isolated (e.g. by a common polymer cladding surrounding the core of the first and the second waveguide, favoured by the generally low thermal conductivity of polymer materials) such that the waveguides may assume different temperatures. For example, the heating device comprises at least two separate heating electrodes, wherein at least one heating electrode is assigned to the first optical waveguide and at least one heating electrode is assigned to the second optical waveguide.

It is, of course, also possible that only one heating electrode is provided such that only one waveguide can be heated. Further, it is conceivable that the heating device is configured for simultaneously heating the first and the second optical waveguide, making use of the different TOCs of the waveguides.. For example, the heating device comprises a single heating electrode assigned to both the first and the second optical waveguide (having different thermo-optical coefficients). The heaters may be applied to the top of the waveguide structures but also at the bottom or at the sidewalls of etched mesa-like stripes encompassing both of the waveguides.

The invention also relates to an optical add-drop multiplexer (OADM) that comprises a directional coupler as described above. For example, an input port of the first or the second optical waveguide of the directional coupler is connected to different WDM-channels (WDM = wavelength division multiplex), wherein using the directional coupler a wavelength channel can be deselected (drop function) and/or added (add-function) by tuning the device to this particular wavelength. The directional coupler according to the invention may allow a relatively broad tuning range such that optical add-drop-multiplexer for coarse wavelength division multiplex (CWDM) applications may be realized which do not require particularly narrow filter characteristics. For example, an optical add-drop multiplexer for four CWDM-channels having, for example, 20 nm channel spacing may be fabricated.

Also, the directional coupler according to the invention may be used as a wavelength tuneable / wavelength selectable thermo-optical wavelength switch or power divider; in particular, as a 2 x 2 wavelength switch or power divider. According to this embodiment, light of a predetermined wavelength will be fed into one of the coupler waveguides and if the wavelength matches the coupling wavelength of the coupler, the light will be transferred to the other coupler waveguide (or vice versa). This switch can be operated with low losses, in particular, essentially as a no-loss device (apart from inevitable waveguide or fabrication induced losses).

A complete switching may already be achieved by inducing small temperature changes (e.g. a temperature rise of not more than 10 K) depending on the spectral characteristic of the directional coupler. For example, the centre wavelength (i.e. the maximum of the transmitted spectrum) of the directional coupler is tuned to the input wavelength as set forth above. It is, however, also possible that the directional coupler is tuned in such a way that the input wavelength lies on an edge of the transmitted wavelength range of the coupler such that only a (first) portion of the input power is transferred to the other wave guide, whereas a second portion of the input power remains in the input waveguide. Thus, the directional coupler may be used as.an optical power divider having an adjustable split ratio.

According to another embodiment of the invention, a tuneable laser device comprising an intra-cavity filter for selecting an output wavelength of the laser is provided, the intra-cavity filter comprising a directional coupler as discussed above. Thus, the directional coupler is used as a widely tuneable filter for tuning the laser. For example, an input port (i.e. an ending) of the first or the second optical waveguide of the directional coupler is connected to a laser active component (gain component), wherein an output port of the other optical waveguide is connected to a reflecting element (e.g. a multiple peak reflector) of the laser. The directional coupler is used to select one of the plurality of cavity modes permitted by the reflecting element, wherein a cavity mode wavelength is selected by tuning the centre wavelength of the directional coupler as described above (e.g. by heating at least one of the coupler waveguides).

In particular, the laser device is a hybrid device, wherein at least the gain component is a semiconductor component (i.e. in particular, its laser active part is a semi-conductor structure) and the directional coupler is formed as a polymer component (having at least one polymer waveguide) according to the invention. Accordingly, the gain component and the coupler are arranged on different substrates connected to one another.

Further, the invention also relates to a tuneable laser device comprising a first and a second laser and a directional coupler as described above, wherein light emitted by the first laser is coupled into the first optical waveguide of the directional coupler and light emitted by the second laser is coupled into the second optical waveguide of the directional coupler. In particular, the first and the second lasers are designed as waveguide grating lasers (WGL) containing waveguides with tuneable Bragg gratings.

The two Bragg grating loaded waveguides are, for example, integrated on a common substrate (chip) and hybridly integrated with semi-conductor devices to form a dual WGL structure. The two lasers further are connected to an output port of the laser device via the directional coupler, wherein light emitted by one of the waveguides of the directional coupler is guided towards that output port.

In particular, the two waveguide grating lasers cover different tuning ranges, wherein depending on the desired output wavelength either the first or the second laser is operated. The coupling wavelength of the directional coupler is selected correspondingly such that light of the active laser is guided towards the output port of the laser device. In that example, the directional coupler operates as a switch, which, in particular, has low optical losses and has to only operate in half of the tuning range of the laser device and requires little heating power due to its efficiency.

It is also possible to operate the directional coupler in such a way that only a portion of the optical power generated by the first or the second laser of the laser device is transferred between the optical waveguides of the directional coupler such that a portion of the power will be emitted via a second output port of the directional coupler. This configuration may be used, for example, in optical coherent transceivers for using the same laser device simultaneously as a local oscillator laser and an externally modulated transmitting laser.

Embodiments of the invention will be explained in more detail hereinafter with reference to the drawings, in which:

Fig. 1    schematically depicts an optical waveguide;

Fig. 2    schematically depicts another optical waveguide;

Fig. 3    the difference of the effective refractive index depending on the thickness of the dielectric waveguide core;

Fig. 4    depicts a segmented optical waveguide;

Fig. 5    depicts a modification of the optical waveguide of Fig. 4;

| | |
|---|---|
| Fig. 6 | illustrates overlap of the optical mode at the facet of the waveguide of Fig. 4 with a mode of an optical component; |
| Fig. 7A | shows a direction coupler according to an embodiment of the invention; |
| Fig. 7B | shows a cross sectional view of the direction coupler of Fig. 7A; |
| Fig. 8A, 8B | illustrate a heat-induced change of the wavelength characteristics of the directional coupler according to the invention; |
| Fig. 9 | illustrates the potential tuning range of the directional coupler according to the invention; |
| Fig. 10 | depicts a sectional view of the directional coupler according to an embodiment of the invention; |
| Fig. 11 | depicts a schematic sectional view of the directional coupler according to another embodiment of the invention; |
| Fig. 12 | schematically illustrates the use of the directional coupler according to the invention in an add-drop multiplexer; |
| Fig. 13 | illustrates the working principle of the add-drop multiplexer shown in Fig. 12; |
| Fig. 14 | illustrates the use of the directional coupler according to the invention as a wavelength dependent switch; |
| Fig. 15 | schematically illustrates the working principle of the switch shown in Fig. 14; |
| Fig. 16 | schematically illustrates a tuneable laser device comprising a directional coupler according to the invention; |
| Fig. 17 | schematically illustrates another tunable laser device comprising a directional coupler according to the invention; and |
| Fig. 18a-18f | schematically illustrates possible configurations of the laser device shown in Fig. 17. |

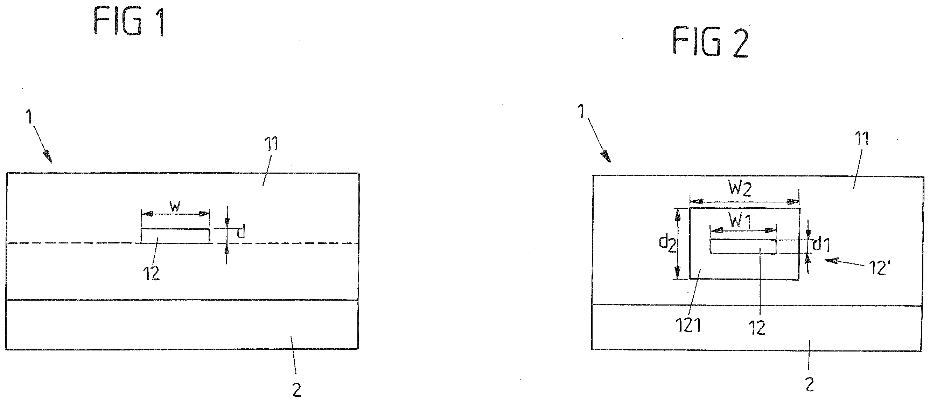

The optical waveguide 1 illustrated in Fig. 1 is arranged on a substrate (e.g. a silicon substrate) 2, waveguide 1 further comprising a polymer cladding 11 in which a waveguide core 12 is embedded. The waveguide core 12 consists of a dielectric material such as silicon nitride. However, dielectrics other than silicon nitride could be used as material for the dielectric waveguide core 12 provided e.g. that they are compatible with the polymer material used for the waveguide cladding 11 (and are sufficiently loss free in the desired wavelength range). The effective refractive index of the optical waveguide 1 depends on the width w (parallel to substrate 2) and the thickness d (perpendicular to substrate 2).

Figure 2 illustrates another waveguide, wherein the waveguide core 12' is not exclusively formed by a dielectric material as in Figure 1. Rather, core 12' comprises a polymer material 121 (different from the polymer material used for the cladding 11) in which a dielectric (inner) core 12 is embedded.

The dimensions (width $w_1$, thickness $d_1$) of the dielectric inner core 12 may compare to the dimensions of dielectric core 12 of Figure 1. The surrounding polymer core 121 may have a width $w_2$ of about 3.5 $\mu$m and a thickness $d_2$ of about 3.5 $\mu$m + $d_1$.

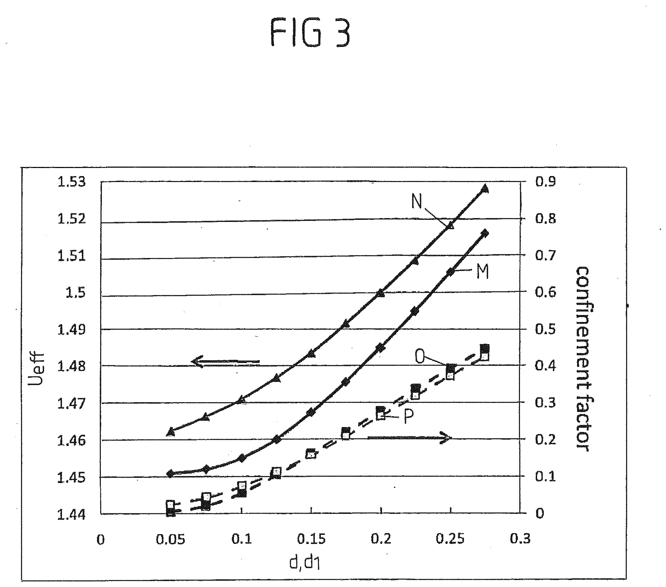

Figure 3 illustrates the effective refractive index $n_{eff}$ (left y-axis) and the confinement factor (right y-axis), respectively, for the two configurations of the optical waveguides shown in Figures 1 and 2 dependent on the thickness d, $d_1$ of the dielectric waveguide core 12. The refractive index increases with increasing thickness (curve M: pure dielectric waveguide core as in Fig. 1, curve N: combined polymer/dielectric core as in Fig. 2). Also, the confinement factor increases with increasing thickness (curve O: pure dielectric waveguide core, curve P: polymer and dielectric core).

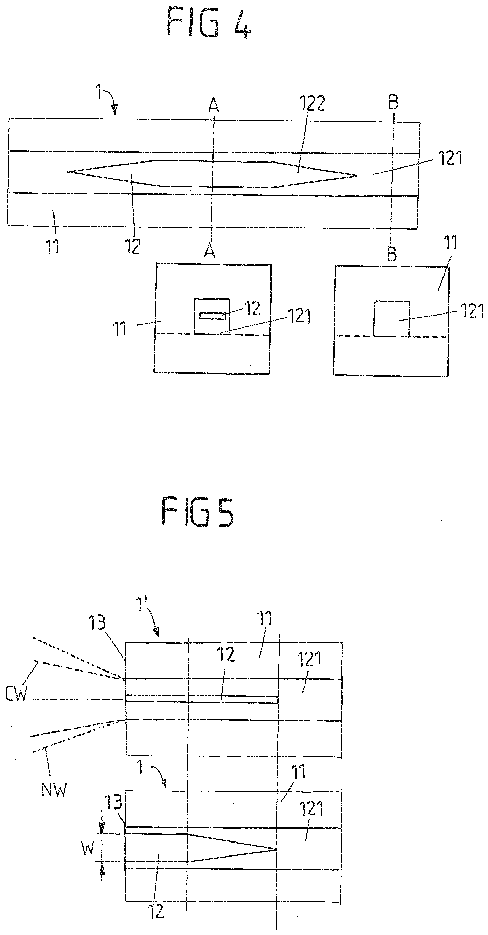

Figure 4 illustrates another embodiment of the optical waveguide 1 in a sectional top view (upper illustration) and in two cross sectional views taken perpendicular to the longitudinal axis of the waveguide (lower illustrations).

The optical waveguide 1 similar to Figures 1 and 2 comprises a dielectric core 12 embedded in a polymer cladding 11. However, the dielectric core 12 does not extend over the whole length of the optical waveguide 1. Rather, only a section of the optical waveguide 1 comprises the dielectric core, wherein other portions of the waveguide do not comprise a dielectric core, but, for example, a polymer core 121 (or a core of another material different form the material of dielectric core 12). This is depicted by the lower sectional views of the optical waveguide depicting sections A-A and B-B of the upper drawing.

Because of the different core sections, the different sections of waveguide 1 comprise different effective refractive indices. For example, the effective refractive index $n_{eff,2}$ of the waveguide section with the dielectric core (left lower sectional view) is larger than the effective refractive $n_{eff,1}$ outside the waveguide section with the dielectric core (right lower sectional view).

Further, the transition region between the dielectric core section and the section outside the dielectric core section may comprise a tapered core region 122, wherein the dielectric core 12 is tapered towards the adjacent section (e.g. a polymer core section), i.e. its width and/or thickness continuously (e.g. linearly or adiabatically) decreases towards the adjacent region to reduce optical transition losses between the sections.

According to Figure 5, using a dielectric core 12 in the region of a facet 13 of waveguide 1, the aperture of waveguide 1 can be enlarged. The enlarged aperture is depicted in the upper drawing of Figure 5 relative to the aperture of the facet of a conventional waveguide having a pure polymer core, wherein the aperture of the conventional waveguide is denominated "CW" and the aperture of the new waveguide is denominated "NW".

The dielectric core 12 of waveguide 1 may further be tapered (lower drawing of Fig. 5) in such a way that its width w increases towards a facet 13 of the optical waveguide 1 such that the waveguide mode at the facet has a larger overlap with an optical mode of a component (particularly one featuring an elliptical mode profile; not illustrated) whose radiation is to be fed into the optical waveguide 1. Thus, the aperture of the optical waveguide 1 is enlarged, thereby reducing coupling losses.

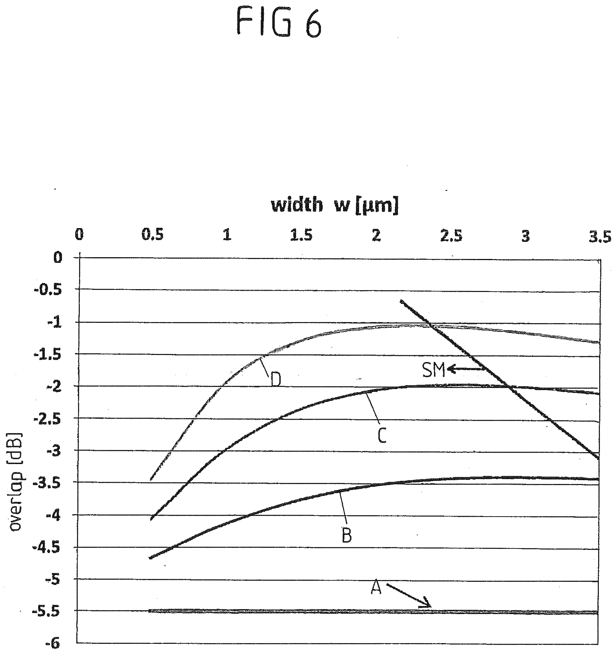

The overlap with an exemplary elliptical mode profile and the mode profile at facet 13 of waveguide 1 dependent on the width w of the dielectric core layer is depicted in Figure 6, wherein the characteristics of the conventional waveguide (curve A) is shown together with the characteristics of the waveguide 1 according to the invention (curve B: w=15 nm, curve C: w=100 nm and curve D: w=115 nm). The conventional polymer waveguide has a polymer core (3.5 x 3.5 $\mu$m). The single mode regime is also indicated (curve SM).

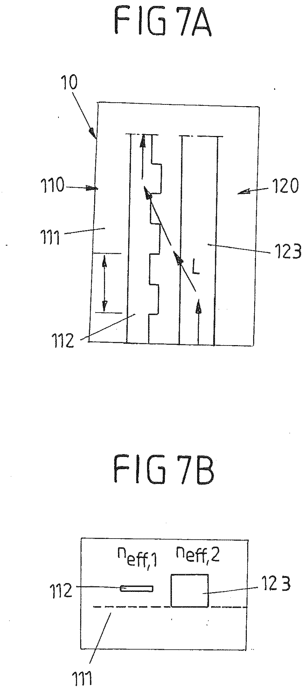

Figure 7A illustrates a directional coupler 10 according to the invention, the directional coupler 10 comprising a first optical waveguide 110 and a second optical waveguide 120. Figure 7B shows the first and the second optical waveguide 110, 120 in cross section.

The first optical waveguide 110 is configured similar to the optical waveguides according to the invention shown in Figure 1, i.e. the optical waveguide 110 comprises a polymer cladding 111 and a dielectric core 112. The other waveguide 120 of the coupler 10 may be a conventional waveguide, e.g. a polymer waveguide without a dielectric core (e.g. having a pure polymer core 123). Further, the cladding 111 forms the cladding of both the first and the second optical waveguide 110, 120.

The directional coupler 10 has a lateral configuration, i.e. the first and the second waveguide 110, 120 are arranged on a substrate (similar to substrate 2 in Fig. 1), wherein the waveguides 110, 120 run parallel to one another in a common plane that extends parallel to the substrate.

Due to the fact that the first optical waveguide 110 comprises a dielectric core, it has a rather large effective refractive index such that the two waveguides 110, 120 have different refractive indices which, in principle, would prevent an optical mode in one of the waveguides from coupling into the other waveguide. However, the effective refractive index of the first optical waveguide 110 varies along the length of the waveguide 110 with a period A, wherein the longitudinal variation of the effective refractive index is generated by providing the dielectric core 112 of the first optical waveguide 110 with a grating-like variation of its width (and/or its thickness), i.e. the directional coupler 10 is a "grating assisted coupler" (GAC). Thus, a transfer (indicated by arrows L in Fig. 7A) of an optical mode (light wave) from the second optical waveguide 120 into the first optical waveguide 110 (or vice versa) is possible for a resonant wavelength which depends on the period length A as already set forth above in more detail.

Because of the dielectric core of the first optical waveguide, also the thermo-optical coefficient of the first optical waveguide 110 is different (e.g. lower) than the thermo-optical coefficient of the second optical waveguide 120. Thus, by changing the temperatures of the first and the second optical waveguide 110, 120, the difference $\Delta n_{eff}$ of their effective refractive indices is altered, thereby changing the resonant (centre) wavelength of the directional coupler 10.

It is possible that both waveguides 110, 120 experience the same temperature change, wherein the tuning wavelength of the coupler 10 would still be altered due to the different thermo-optic coefficients. However, it is also possible that the first and the second optical waveguide have similar thermo-optical coefficients. In that case, the temperature of the first optical waveguide may be changed differently than the temperature of the second optical waveguide, e.g. by using separate heating electrodes as will be explained below. It is also noted that at a certain temperature (e.g. at room temperature) the effective refractive indices of the two optical waveguides may be essentially the same, wherein they are different at another temperature.

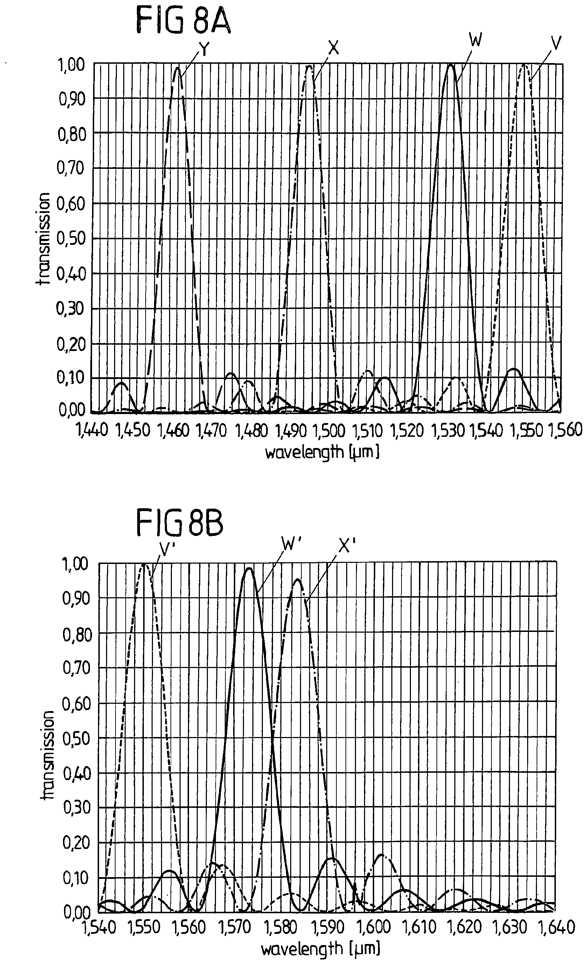

In particular, it is possible that only one of the two optical waveguides 110, 120 is heated at a time, wherein, for example, the coupling wavelength of the directional coupler 10 may be shifted towards smaller wavelengths when only the first optical waveguide 110 (comprising the grating and the dielectric core) is heated and towards larger wavelengths when only the second optical waveguide 120 (polymer waveguide without grating) is heated. This is illustrated in Figures 8A and 8B, wherein Figure 8A shows the transmission of the directional coupler if only the first optical waveguide 110 experiences a change of its temperature (curve V: induced temperature change $\Delta T = 0$K, curve W: $\Delta T = 10$K, curve X: $\Delta T = 30$K and Y: $\Delta T = 50$K). Figure 8B illustrates the transmission (filtering curve) of the directional coupler when only the second optical waveguide 120 is heated (curve V': $\Delta T = 0$K, curve W': $\Delta T = 10$K and X': $\Delta T = 15$K).

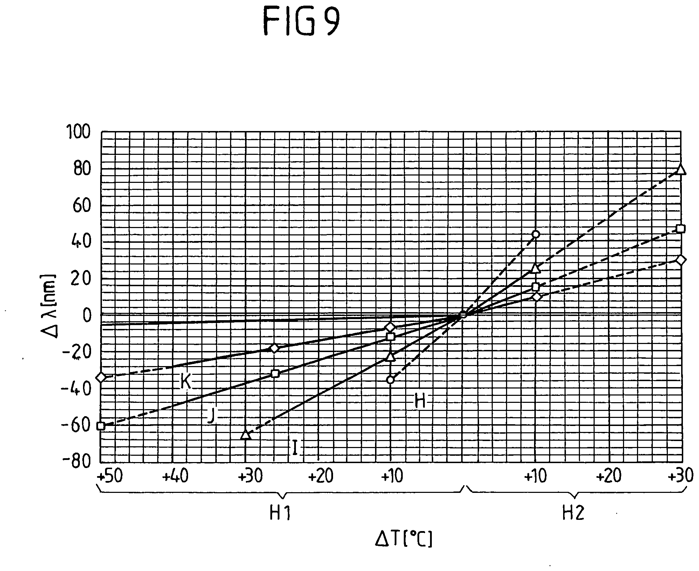

The tuning ranges shown in Figures 8A and 8B can be combined to obtain an overall tuning range of the directional coupler; for example as illustrated in Figure 9 for different thicknesses d of the dielectric core relative to a middle wavelength of 1550 nm (curve H: d = 100nm; curve I: d = 120nm; curve J: d = 150 nm and curve K: d = 200 nm). "H1" denotes the temperature difference created by heating the dielectric core waveguide and "H2" denotes the temperature difference created by heating the polymer core waveguide of the coupler.

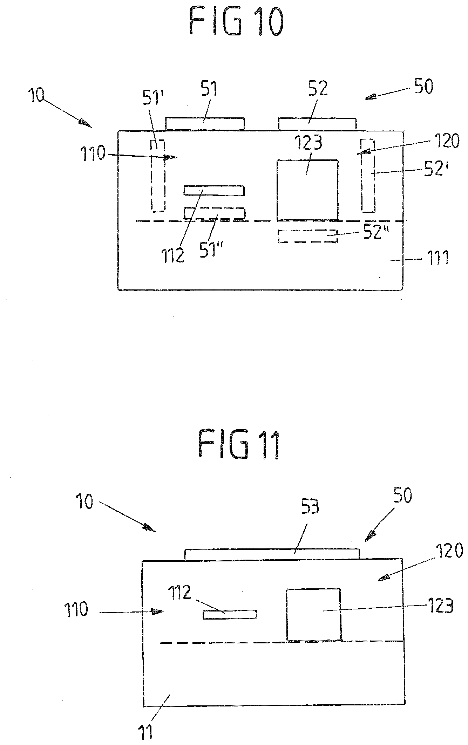

Figure 10 shows a cross section of a further embodiment of the directional coupler 10 according to the invention. In this embodiment the coupler 10 comprises a heating device 50 comprising two heating electrodes 51, 52 assigned to the first optical waveguide 110 and the second optical waveguide 120, respectively. The heating electrodes 51, 52 are arranged in a distance from one another on top of the polymer cladding 111, i.e. on a side of the cores of the optical waveguides 110, 120 which faces away from the substrate (not illustrated in Figure 10) of the coupler 10.

In particular, the heating electrodes 51, 52 are configured in such a way that the temperature of the waveguides 110, 120 can be changed essentially independently from one another. Of course, the heating electrodes 51, 52 do not necessarily have to be arranged on top of the waveguides. Rather, as an alternative or in addition, heating electrodes 51', 52', 51", 52" could be provided that are arranged laterally (e.g. embedded in the cladding 111) and/or below the waveguides 110, 120 (in particular below the waveguide cores) as indicated (dashed lines) in Fig. 10.

It is also possible, that a common heating electrode 53 is used assigned to both the first and the second optical waveguide 110, 120 as depicted in Figure 11. Also in this embodiment further electrodes may be provided arranged below the waveguides as indicated in Fig. 10.

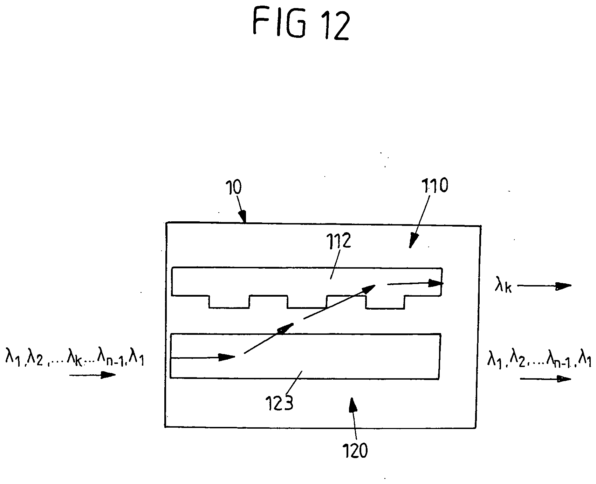

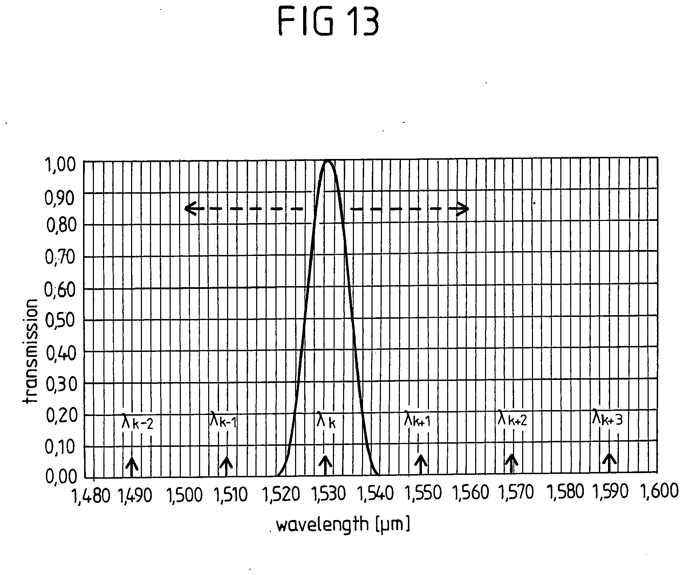

Another embodiment of the invention is illustrated in Figures 12 and 13, wherein the directional coupler according to the invention is used in an optical add-drop multiplexer (OADM) in such a way that a plurality of wavelength channels is connected to one of the waveguides (the second waveguide 120 according to the example of Fig. 12) of the coupler 10. Depending on the tuning wavelength of the directional coupler 10 a certain wavelength channel ($\lambda_k$) is coupled over into the other waveguide (the first waveguide 110 having the dielectric core 112) and emitted from an output facet of the first waveguide towards an output port of the coupler and the mulitplexer. The selected wavelength channel $\lambda_k$ can be changed by tuning the directional coupler 10 (e.g. by heating the first and/or the second optical waveguide 110, 120 as discussed above and as depicted in Figure 13). Of course, also the first optical waveguide 110 could be used as input waveguide.

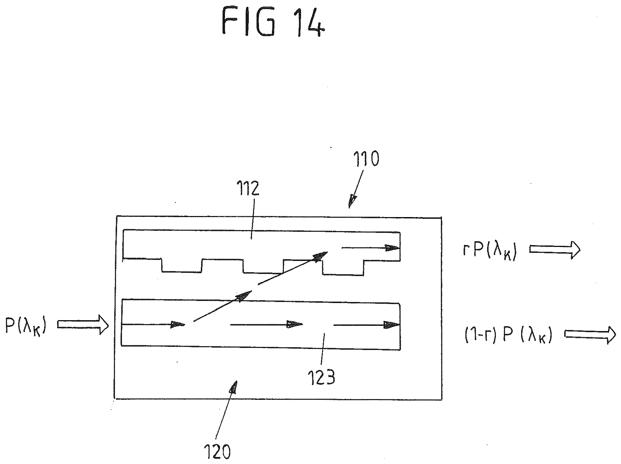

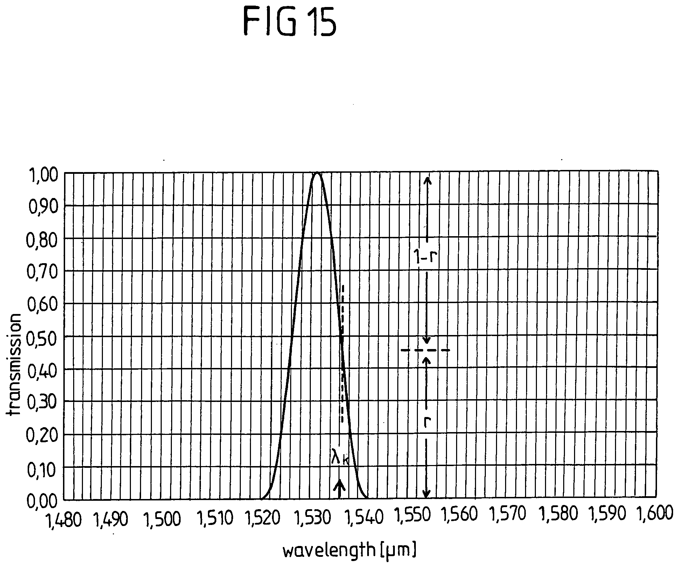

According to Figures 14 and 15, the directional coupler could also be used as a wavelength tuneable thermo-optical switch (2x2 switch), wherein light could be switched from one of the waveguides (lower, second optical waveguide 120) into another waveguide (upper, first optical waveguide 110) as already set forth above. Also, if the tuned-in centre wavelength of directional coupler 10 does not exactly match the input wavelength $\lambda_k$ (but $\lambda_k$ is located on an edge of the transmission curve of coupler 10 as shown in Fig. 15) only a portion of the power P fed into the coupler is transferred to the first waveguide 110, wherein the dividing ratio r of the switch can be adjusted such that only a portion r * P of the power coupled into the second optical waveguide 120 is transferred into the first optical waveguide 110. Accordingly, the remaining power (1-r) * P stays in the second optical waveguide 120 and is emitted from an end of the second optical waveguide 120.

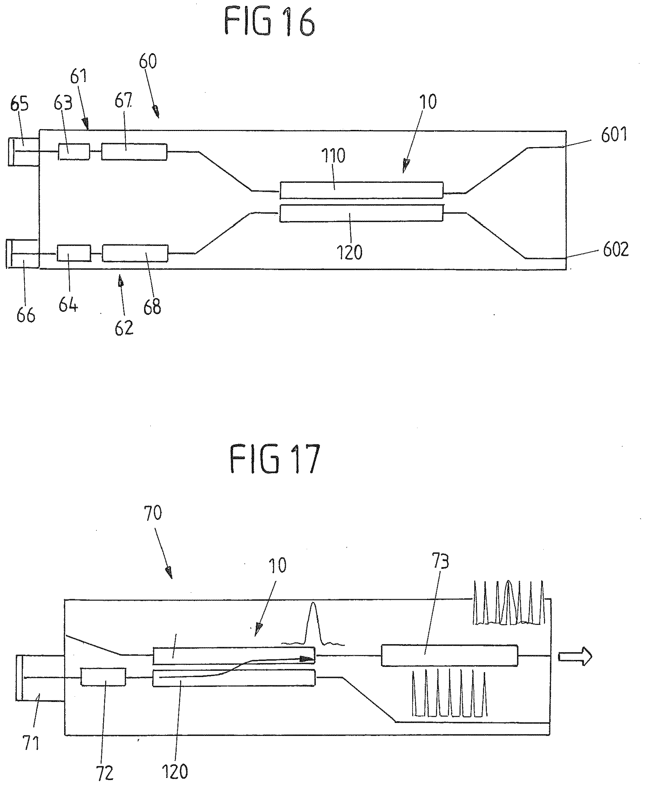

Figure 16 relates to a tuneable laser device 60 comprising a directional coupler 10 according to the invention. The laser device 60 comprises two parallel waveguide grating lasers 61, 62, each of the lasers 61, 62 comprising a phase section 63, 64 and a gain section 65, 66. Further, the lasers 61, 62 comprise a tuneable Bragg filter 67, 68, wherein the lasers 61, 62 are coupled to the first and the second optical waveguide, respectively, of the directional coupler 10 via the Bragg filters 67, 68.

An output end of the first optical waveguide 110 is connected (e.g. via integrated waveguides) to an output port 601 of the laser device 60 and the second optical waveguide 120 is connected to a second output port 602 of laser device 60. The lasers 61, 62 have different (e.g. adjacent) tuning ranges, wherein using the directional coupler as a combiner 10 light of both lasers 61, 62 can be directed towards the same output port (the upper output port 601). The centre wavelength of the directional coupler is set depending on which one of the lasers 61, 62 is operated (as already explained above). Further, laser device 60 may be a hybrid integrated device, i.e. in particular the gain sections 65, 66 and the directional coupler are not realized as an integrated device. In particular, the gain sections 65, 66 or the lasers 61, 62 as a whole are integrated on a common chip.

Figure 17 shows another application of the directional coupler 10 according to the invention. The coupler 10 is used as an intra cavity filter of a laser device 70 in the form of a tuneable laser comprising a gain element 71, a phase section 72 and a multiple peak reflector (comb reflector) 73. Because of the comb reflector 73 the laser device 70 comprises a plurality of equally distanced lasing wavelengths, wherein the directional coupler 10 is used to select one of these wavelengths by tuning its coupling wavelength to the desired wavelength. The comb reflector may be a SG (sample grating) or a SSG (super structure grating) reflector.

Laser device 70 may also be a hybrid integrated device, wherein some of the components may be semiconductor (e.g. indium phosphide) based components (such as the gain element 71) and some may be polymer based components (such as the directional coupler 10), i.e., in particular, passive and/or active elements of the components are made by semiconductor layers and polymer layers, respectively.

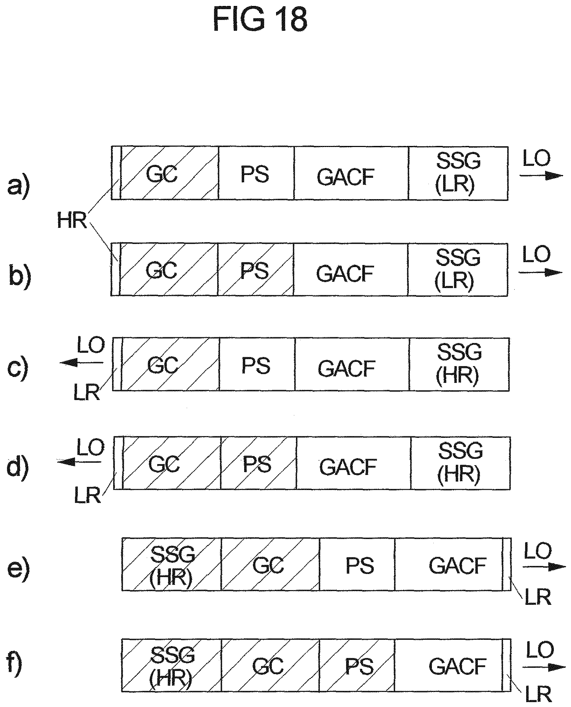

Figures 18a to 18f illustrate different embodiments of realising the hybrid integrated laser device 70 of Figure 17, wherein the different embodiments comprise different configurations of the components of the laser device such as the gain section 71 (GC = "Gain Chip"), the phase section 72 (PS), the directional coupler 10 used as a cavity filter (GACF = Grating Assisted Cavity Filter), the comb reflector (SSG = Super Structure Grating), a high reflective mirror (e.g. coating) (HR) and a low reflective coating (e.g. a partially reflecting, broadband reflector in an output waveguide or a facet of the waveguide) (LR). The light output direction is indicated by "LO" ("light out").

The different configurations of the laser device 70 may be obtained, for example, by varying the order (i.e. the location along the light path of the laser) of the components of the device. Further, some of the components may be either semi-conductor based or polymer based. For example, the phase section 72 may be either a semi-conductor or a polymer component. The semi-conductor (e.g. InP) components are indicated by hatched rectangular areas, whereas the polymer components are symbolized by non-hatched areas.

The laser device configurations shown in Fig. 18 a-f may have the potential to cover a tuning range corresponding to the C+L bandwidth (85 nm). Further, in comparison with WGL components the temperature change required for tuning the laser wavelength (i.e. for tuning the directional coupler as a polymer device) is relatively small, for the benefit of enhanced reliability.

It is noted that elements of different embodiments described above can, of course, also be used in combination. For example, the directional coupler used as an intra-cavity filter according to the embodiment of Fig. 17 may be equipped with at least one optical waveguide according to the embodiment of Fig. 2.

## Claims

1. Directional coupler, comprising

   - a first and a second optical waveguide (110, 120) extending at least partially parallel to one another, wherein
   - the first optical waveguide (110) has a core (112) that at least partially comprises or consists of a dielectric material; and
   - a polymer cladding (111) forming the cladding of both the first and the second optical waveguide (110, 120), wherein
   - the first and the second optical waveguide (110, 120) are arranged on a substrate in such a way that they extend in common plane running essentially parallel to the substrate,

   **characterized in that**
   the second optical waveguide (120) has a polymer core (123).

2. Directional coupler as claimed in claim 1, wherein the effective refractive index of the first optical waveguide (110) is different from the effective refractive index of the second optical waveguide (120).

3. Directional coupler as claimed in one of the preceding claims, wherein the effective refractive index of the first and/or the second optical waveguide (110, 120) varies periodically along the respective waveguide (110, 120).

4. Directional coupler as claimed in claim 3, wherein the periodic variation of the first and/or the second optical waveguide (110, 120) is created by varying

the thickness (d, $d_1$) - measured perpendicular to the substrate and/or the width measured parallel to the substrate of the dielectric material of the core (112) of the first or the second optical waveguide (110, 120), respectively.

5. Directional coupler as claimed in one of the preceding claims, wherein the thermo-optical coefficient of the first optical waveguide (110) is different from the thermo-optical coefficient of the second optical waveguide (120).

6. Directional coupler as claimed in one of the preceding claims, wherein the first optical waveguide (110, 120) comprises a core (112) consisting or comprising of at least one of the group comprising silicon nitride, tantalum oxide, titanium oxide and aluminium oxide.

7. Directional coupler as claimed in one of the preceding claims, further comprising a heating device (50) for heating the first and the second optical waveguide (110, 120), wherein the heating device (50) is configured in such a way that the temperature of the first and the second optical waveguide (110, 120) can be changed essentially independently from one another.

8. Optical add-drop multiplexer comprising at least one directional coupler (10) as claimed in one of the preceding claims for selecting an add/drop wavelength.

9. Tuneable laser device comprising an intra-cavity filter for selecting an output wavelength of the laser, wherein the intra-cavity filter comprises a directional coupler (10) as claimed in one of the claims 1 to 7.

10. Tuneable laser device comprising a first and a second laser (61, 62) and a directional coupler (10) as claimed in one of the claims 1 to 7, wherein light emitted by the first laser (61) is coupled into the first optical waveguide (110) of the directional coupler (10) and light emitted by the second laser (62) is coupled into the second optical waveguide (120) of the directional coupler (10).

11. Tuneable laser as claimed in claim 10, wherein the first and the second laser (61, 62) are waveguide grating lasers.

## Patentansprüche

1. Richtkoppler, der Folgendes umfasst

   - einen ersten und einen zweiten Lichtwellenleiter (110, 120), die sich mindestens teilweise parallel zueinander erstrecken, wobei
   - der erste Lichtwellenleiter (110) einen Kern (112) aufweist, der mindestens teilweise ein Dielektrikummaterial umfasst oder aus einem solchen besteht; und

- einen Polymermantel (111), der den Mantel sowohl des ersten als auch des zweiten Lichtwellenleiters (110, 120) bildet, wobei

- der erste und der zweite Lichtwellenleiter (110, 120) derart auf einem Substrat angeordnet sind, dass sie sich in einer gemeinsamen Ebene erstrecken und im Wesentlichen parallel zum Substrat verlaufen,

**dadurch gekennzeichnet, dass**

der zweite Lichtwellenleiter (120) einen Polymerkern (123) aufweist.

**2.** Richtkoppler nach Anspruch 1, wobei sich der effektive Brechungsindex des ersten Lichtwellenleiters (110) vom effektiven Brechungsindex des zweiten Lichtwellenleiters (120) unterscheidet.

**3.** Richtkoppler nach einem der vorhergehenden Ansprüche, wobei der effektive Brechungsindex des ersten und/oder des zweiten Lichtwellenleiters (110, 120) entlang des jeweiligen Wellenleiters (110, 120) periodisch variiert.

**4.** Richtkoppler nach Anspruch 3, wobei die periodische Variation des ersten und/oder des zweiten Lichtwellenleiters (110, 120) durch Variieren der Dicke $(d, d_1)$ - im rechten Winkel zum Substrat gemessen, und/oder der Breite, parallel zum Substrat des Dielektrikummaterials des Kerns (112) des ersten bzw. des zweiten Lichtwellenleiters (110, 120) gemessen, erstellt wird.

**5.** Richtkoppler nach einem der vorhergehenden Ansprüche, wobei sich der thermooptische Koeffizient des ersten Lichtwellenleiters (110) vom thermooptischen Koeffizient des zweiten Lichtwellenleiters (120) unterscheidet.

**6.** Richtkoppler nach einem der vorhergehenden Ansprüche, wobei der erste Lichtwellenleiter (110, 120) einen Kern (112) umfasst, der aus mindestens einem der Gruppe, die Siliziumnitrid, Tantaloxid, Titanoxid und Aluminiumoxid umfasst, besteht oder eines von diesen umfasst.

**7.** Richtkoppler nach einem der vorhergehenden Ansprüche, der ferner eine Heizvorrichtung (50) zum Erwärmen des ersten und des zweiten Lichtwellenleiters (110, 120) umfasst, wobei die Heizvorrichtung (50) derart ausgelegt ist, dass sie Temperatur des ersten und des zweiten Lichtwellenleiters (110, 120) im Wesentlichen unabhängig voneinander geändert werden kann.

**8.** Optischer Add-Drop-Multiplexer, der mindestens einen Richtkoppler (10) nach einem der vorhergehenden Ansprüche zum Auswählen einer Add-/Drop-Wellenlänge umfasst.

**9.** Abstimmbare Laservorrichtung, die einen Intra-Cavity-Filter zum Auswählen einer Ausgangswellenlänge des Lasers umfasst, wobei der Intra-Cavity-Filter einen Richtkoppler (10) nach einem der Ansprüche 1 bis 7 umfasst.

**10.** Abstimmbare Laservorrichtung, die einen ersten und einen zweiten Laser (61, 62) sowie einen Richtkoppler (10) nach einem der Ansprüche 1 bis 7 umfasst, wobei das Licht, das vom ersten Laser (61) emittiert wird, in den ersten Lichtwellenleiter (110) des Richtkopplers (10) gekoppelt wird und Licht, das vom zweiten Laser (62) emittiert wird, in den zweiten Lichtwellenleiter (120) des Richtkopplers (10) gekoppelt wird.

**11.** Abstimmbarer Laser nach Anspruch 10, wobei der erste und der zweite Laser (61, 62) Wellenleitergitterlaser sind.

**Revendications**

**1.** Coupleur directionnel, comprenant

- un premier et un second guide d'onde optique (110, 120) s'étendant au moins partiellement parallèlement l'un à l'autre, dans lequel
- le premier guide d'onde optique (110) possède un coeur (112) qui comprend ou se compose au moins partiellement d'un matériau diélectrique ; et
- un gaine polymère (111) formant la gaine à la fois du premier et du second guide d'onde optique (110, 120), dans lequel
- le premier et le second guide d'onde optique (110, 120) sont agencés sur un substrat de sorte qu'ils s'étendent dans un plan commun sensiblement parallèle au substrat,

**caractérisé en ce que**

le second guide d'onde optique (120) possède un coeur en polymère (123).

**2.** Coupleur directionnel selon la revendication 1, dans lequel l'indice de réfraction efficace du premier guide d'onde optique (110) est différent de l'indice de réfraction efficace du second guide d'onde optique (120).

**3.** Coupleur directionnel selon l'une des revendications précédentes, dans lequel l'indice de réfraction efficace du premier et/ou du second guide d'onde optique (110, 120) varie périodiquement le long du guide d'onde respectif (110, 120).

4. Coupleur directionnel selon la revendication 3, dans lequel la variation périodique du premier et/ou du second guide d'onde optique (110, 120) est créée par la variation de l'épaisseur $(d, d_1)$ mesurée perpendiculairement au substrat et/ou de la largeur mesurée parallèlement au substrat du matériau diélectrique du coeur (112) du premier ou du second guide d'onde optique (110, 120), respectivement.

5. Coupleur directionnel selon l'une des revendications précédentes, dans lequel le coefficient thermo-optique du premier guide d'onde optique (110) est différent du coefficient thermo-optique du second guide d'onde optique (120).

6. Coupleur directionnel selon l'une des revendications précédentes, dans lequel le premier guide d'onde optique (110, 120) comprend un coeur (112) consistant en ou comprenant au moins élément du groupe comprenant du nitrure de silicium, de l'oxyde de tantale, de l'oxyde de titane et de l'oxyde d'aluminium.

7. Coupleur directionnel selon l'une des revendications précédentes, comprenant en outre un dispositif chauffant (50) pour chauffer le premier et le second guide d'onde optique (110, 120), dans lequel le dispositif chauffant (50) est conçu de telle sorte que la température du premier et du second guide d'onde optique (110, 120) puisse être changée de manière sensiblement indépendante l'une de l'autre.

8. Multiplexeur d'insertion-extraction optique comprenant au moins un coupleur directionnel (10) selon l'une des revendications précédentes pour sélectionner une longueur d'onde d'insertion-extraction.

9. Dispositif laser accordable comprenant un filtre intracavité permettant de sélectionner une longueur d'onde de sortie du laser, le filtre intracavité comprenant un coupleur directionnel (10) selon l'une des revendications 1 à 7.

10. Dispositif laser accordable comprenant un premier et un second laser (61, 62) et un coupleur directionnel (10) selon l'une des revendications 1 à 7, dans lequel une lumière émise par le premier laser (61) est couplée dans le premier guide d'onde optique (110) du coupleur directionnel (10) et une lumière émise par le second laser (62) est couplée dans le second guide d'onde optique (120) du coupleur directionnel (10).

11. Laser accordable selon la revendication 10, dans lequel le premier et le second laser (61, 62) sont des lasers à réseau de guides d'onde.

FIG 1

FIG 2

EP 2 696 227 B1

# FIG 3

# FIG 4

# FIG 5

# FIG 6

width  w [µm]

overlap [dB]

D

SM

C

B

A

# FIG 7A

10

110

111

112

120

123

L

# FIG 7B

$n_{eff,1}$   $n_{eff,2}$

112

123

111

## FIG 8A

## FIG 8B

# FIG 9

EP 2 696 227 B1

## FIG 10

## FIG 11

# FIG 12

$\lambda_1, \lambda_2, \ldots \lambda_k \ldots \lambda_{n-1}, \lambda_1$

$\lambda_k \longrightarrow$

$\lambda_1, \lambda_2, \ldots \lambda_{n-1}, \lambda_1$

# FIG 13

# FIG 14

$$P(\lambda_K) \Longrightarrow$$

$$r\,P(\lambda_K) \Longrightarrow$$

$$(1\text{-}r)\,P(\lambda_K) \Longrightarrow$$

110

112

123

120

# FIG 15

## FIG 16

## FIG 17

# FIG 18

a)

b)

c)

d)

e)

f)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 10025307 B4
- US 6311004 B1
- US 5857039 B1
- US 6282335 B

**Non-patent literature cited in the description**

- **M. MARCUSE.** Directional couplers made of non-identical asymmetrical slabs, Part II: Grating assisted couplers. *J. Lightwave Technol.,* 1987, vol. 5, 268-273